Europäisches Patentamt

European Patent Office

Office européen des brevets

(11) Veröffentlichungsnummer : **0 191 902**
B1

(12) # EUROPÄISCHE PATENTSCHRIFT

(45) Veröffentlichungstag der Patentschrift :
21.12.88

(51) Int. Cl.⁴ : **H 05 K   7/14**

(21) Anmeldenummer : 85112837.1

(22) Anmeldetag : 10.10.85

(54) Aufbausystem für Geräte der elektrischen Nachrichtentechnik.

(30) Priorität : 24.01.85 DE 3502295

(43) Veröffentlichungstag der Anmeldung :
27.08.86 Patentblatt 86/35

(45) Bekanntmachung des Hinweises auf die Patenterteilung : 21.12.88 Patentblatt 88/51

(84) Benannte Vertragsstaaten :
AT BE DE FR GB IT NL SE

(56) Entgegenhaltungen :
EP--A-- 0 037 882
DE--A-- 2 304 456
DE--A-- 2 615 642
DE--U-- 7 215 350
US--A-- 3 798 762
US--A-- 3 808 505
US--A-- 3 923 360
US--A-- 4 016 463
ELONCO BULLETIN, Nr. 68, September 1971, Seiten
2-13,, Philips, Eindhoven, NL; "Moderne verbindingstechnieken"

(73) Patentinhaber : ANT Nachrichtentechnik GmbH
Gerberstrasse 33
D-7150 Backnang (DE)

(72) Erfinder : Schomers, Josef. Dipl.-Ing.
Villinger Strasse 12
D-7150 Backnang (DE)
Erfinder : Erbele, Kurt
Hohenstaufenstrasse 10
D-7153 Weissach i.T. (DE)
Erfinder : Bonk, Wernfried, Dipl.-Ing.
Narzissenweg 12
D-7159 Auenwald (DE)

**Beschreibung**

Die Erfindung betrifft ein Aufbausystem für Geräte der elektrischen Nachrichtentechnik gemäß dem Oberbegriff des Patentanspruches 1. Ein solches Aufbausystem ist aus der deutschen Gebrauchsmusterschrift 72 15 350 bekannt. Es besteht aus Steckbaugruppen, welche elektrische Bauelemente und an einer Kante Steckerleisten tragen. Mehrere Steckbaugruppen werden von vorne in ein Magazin eingesteckt, welches an seiner Rückseite eine Rückwandleiterplatte trägt. Diese trägt Buchsenleisten, in die die Steckerleisten eingreifen. Die Buchsenleisten sind elektrisch untereinander mittels Leiterbahnen der Rückwandleiterplatte verbunden. Größere Geräte bestehen aus mehreren solchen Magazinen, die elektrisch untereinander durch Kabelbäume verbunden sind. Diese Kabelbäume werden in personalaufwendiger Handarbeit hergestellt, wobei sich Fehler einschleichen können. Wegen dieser Handarbeit ist ferner die Lage der einzelnen Drähte in den Kabelbäumen von Exemplar zu Exemplar unterschiedlich. Das hat zur Folge, daß ihre elektrischen Eigenschaften, besonders die Nebensprechdämpfung zwischen zwei Drähten oder Drahtpaaren, ebenfalls unterschiedlich und nicht vorhersehbar ist. Dies schränkt die Verwendbarkeit von Kabelbäumen bei Nachrichtensignalen mit höheren Frequenzen ein.

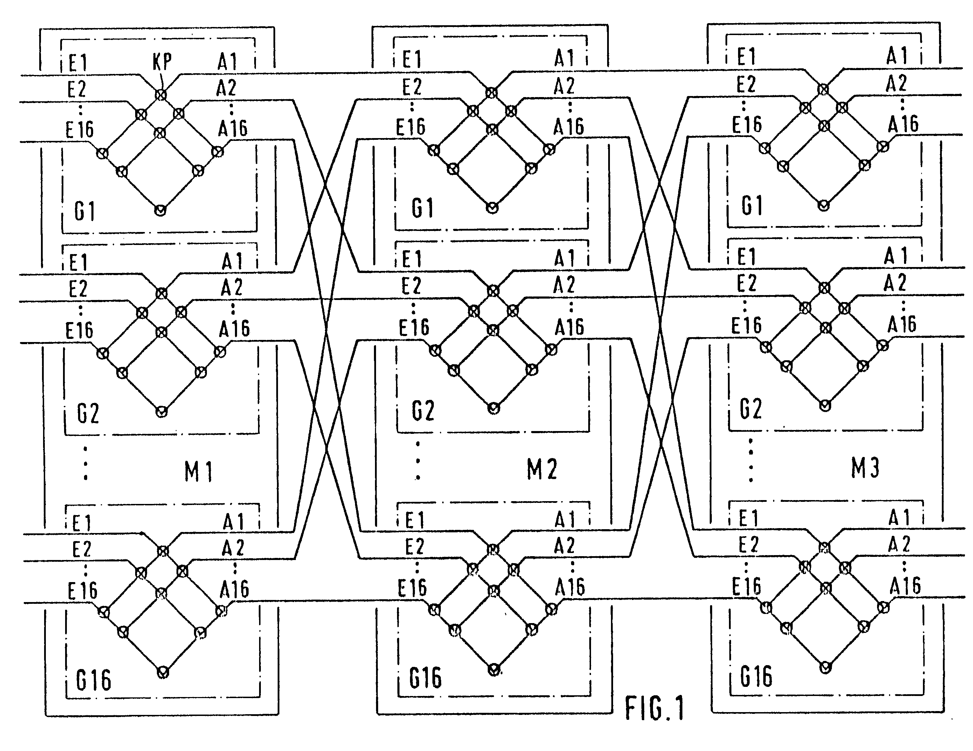

Bei vielen Geräten sind zwischen den einzelnen Magazinen eine sehr große Zahl von Verbindungen nötig, wobei diese auf dem einen Magazin in einer bestimmten Ordnung entspringen, jedoch auf dem anderen Magazin in einer völlig anderen Ordnung enden. Dies wird anhand der Figur 1 verdeutlicht.

Die Figur 1 zeigt als Übersichtsplan ein dreistufiges Koppelfeld für eine Nachrichtenvermittlungsanlage. Jede Stufe besteht aus 16 Teilkoppelfeldern. Für die Verwirklichung eines solchen Koppelfeldes bietet sich das zuvor beschriebene Aufbausystem an. So wird man die Teilkoppelfelder als Steckbaugruppen ausbilden und diese nach Stufen geordnet in Magazine unterbringen. So ergeben sich im Beispiel der Figur 1 je Stufe 16 Steckbaugruppen G1 bis G16 mit je einem Teilkoppelfeld. Jedes Teilkoppelfeld besteht aus 256, in einer 16 × 16-Matrix angeordnete Koppelpunkte KP.

Die jeweils 16 Teilkoppelfelder, also die 16 Steckbaugruppen G1 bis G16 einer Stufe sind in einem eigenen Magazin untergebracht, die der ersten Stufe in einem ersten Magazin M1, die der zweiten Stufe in einem zweiten Magazin M2 und die der dritten Stufe in einem dritten Magazin M3.

Jede Steckbaugruppe weist 16 Eingänge E1 bis E16 und 16 Ausgänge A1 bis A16 auf. Da diese Ein- und Ausgänge auch alle aus dem jeweiligen Magazin herausgeführt sind, weist jedes Magazin, also jede Stufe, 256 Eingänge und 256 Ausgänge auf. In nicht dargestellter Weise sind die 256 Eingänge der ersten Stufe mit 256 Nachrichtenquellen und die 256 Ausgänge der dritten Stufe mit 256 Nachrichtensenken verbunden. Die 256 Ausgänge der ersten Stufe sind mit den 256 Eingängen der zweiten Stufe und deren 256 Ausgänge mit den 256 Eingängen der dritten Stufe nach dem in folgender Tabelle 1 angegebenen Schema verbunden :

| erste bzw. zweite Stufe | | zweite bzw. dritte Stufe | |
|---|---|---|---|
| Steckbaugruppe | Ausgang | Steckbaugruppe | Eingang |
| G1 | A1 | G1 | E1 |
| | A2 | G2 | E1 |
| | . | . | . |
| | . | . | . |
| | . | . | . |
| | A16 | G16 | E1 |
| G2 | A1 | G1 | E2 |
| | A2 | G2 | E2 |
| | . | . | . |
| | . | . | . |
| | . | . | . |
| | A16 | G16 | E2 |
| usw. | | | usw. |
| bis | | | bis |
| G16 | A1 | G1 | E16 |
| | A2 | G2 | E16 |
| | . | . | . |
| | . | . | . |
| | . | . | . |
| | A16 | G16 | E16 |

Aufgabe der Erfindung ist es, ein Aufbausystem für Geräte der elektrischen Nachrichtentechnik der im Oberbegriff des Anspruches 1 genannten Art so weiterzubilden, daß folgende Forderungen erfüllt sind :

a) Es sollen die handelsüblichen mechanischen Teile wie Magazine, Steckbaugruppen, Stecker- und Buchsenleisten verwendet werden können, z. B. die aus dem Intermas-Aufbausystem.

b) Die elektrischen Verbindungen zwischen zwei benachbarten Magazinen sollen so gestaltet sein, daß folgende Bedingungen erfüllt sind :

b1) Fehlerfreie und wenig personalaufwendige Herstellung.

b2) Geeignet für eine Vielzahl von einzelnen Verbindungen.

b3) Die Verbindungen können auf den Magazinen in unterschiedlichen Ordnungen entspringen bzw. enden. Es soll nicht nur das in der Tabelle 1 angegebene Schema sondern jedes beliebige verwirklicht werden können.

b4) Geringe Exemplarsteuerungen der elektrischen Eigenschaften.

Diese Aufgabe wird durch die im Kennzeichen des Anspruchs 1 genannten Merkmale gelöst. Durch die Weiterbildung nach dem Anspruch 2 wird das Aufbausystem für die Übertragung von Datensignalen mit einer Bitrate bis zu 150 MBit/s ausgestaltet.

Das zuvor erwähnte Intermas-Aufbausystem ist in der deutschen Zeitschrift « Technische Mitteilungen AEG-TELEFUNKEN » 62. Jg. (1972) H. 4/5, S. 148 bis 162 beschrieben. Aus genormten Teilen lassen sich Steckbaugruppen (dort Baugruppen oder steckbare Leiterplatten genannt) aufbauen, die sich in ebenfalls genormte Magazine (dort Volleinsätze genannt) einschieben lassen.

Ein dreistufiges Koppelfeld ist in der europäischen Patentschrift 0 037 882 beschrieben. Es erfordert Leiterplatten, welche um 90° verdreht mit ihren Stirnseiten aneinander stoßen. Über irgendeine Halterung dieser Leiterplatten und ihre Unterbringung in ein Magazin lehrt diese Schrift nichts. Es scheint eine Spezialkonstruktion notwendig zu sein. Außerdem können die Verbindungen zwischen den einzelnen Stufen nicht beliebig geführt werden. Mit diesem bekannten mehrstufigen Koppelfeld lassen sich also die dieser Erfindung zu Grunde liegenden Teilaufgaben a) und b3) nicht lösen.

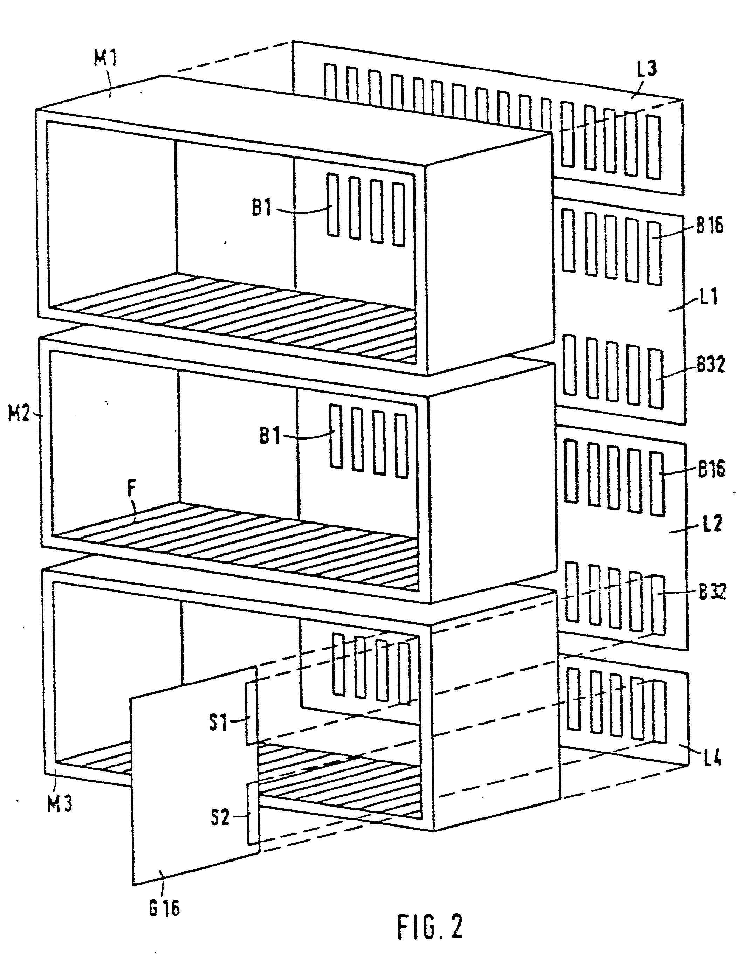

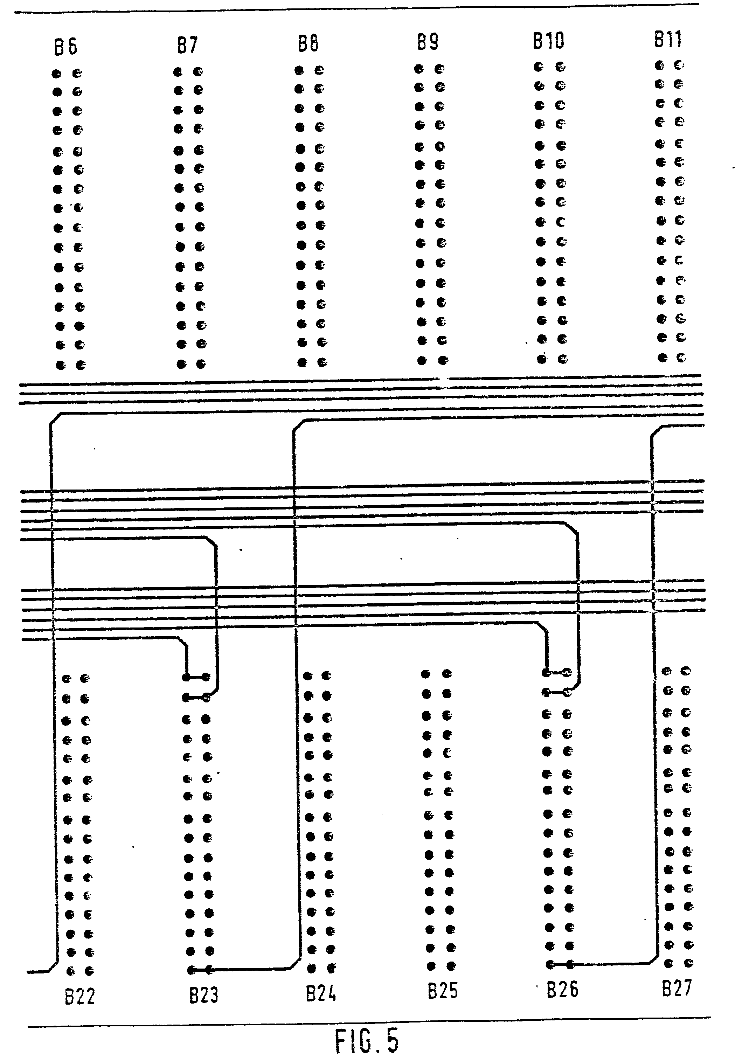

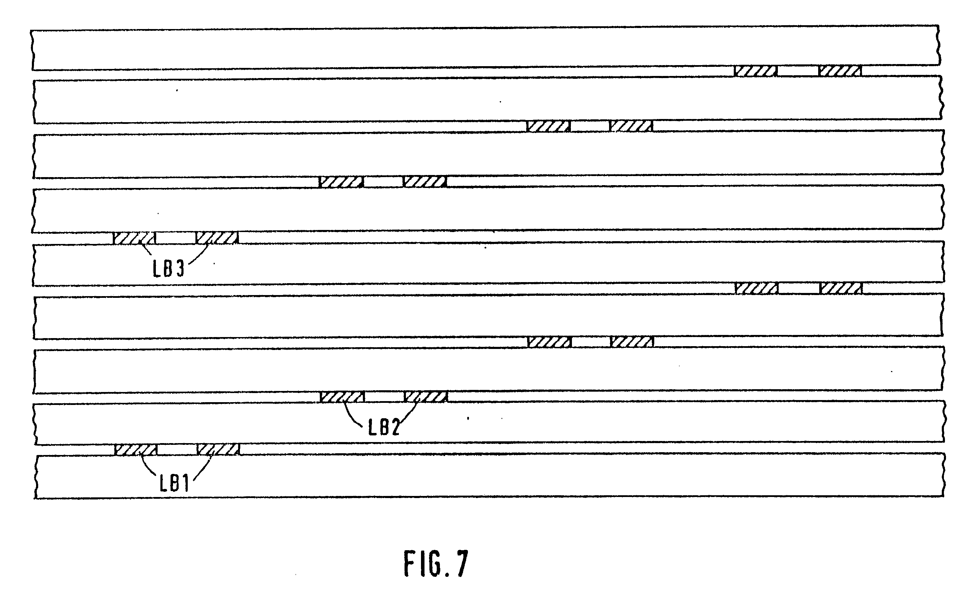

Die Erfindung wird anhand eines in den Figuren 2 bis 7 dargestellten Ausführungsbeispiels beschrieben, wobei die Figuren 2 bis 6 den Patentanspruch 1 betreffen und wobei anhand der Figur 7 ein Merkmal des Patentanspruches 2 erläutert wird. Dieses Ausführungsbeispiel zeigt, wie das in der Figur 1 gezeigte Koppelfeld durch das erfindungsgemäße Aufbausystem in vorteilhafter Weise aufgebaut werden kann.

Die Figur 2 zeigt wieder die drei Magazine M1 bis M3, und zwar hier ihre mechanische Anordnung übereinander. Das erste Magazin M1 befindet sich oben, darunter ist das zweite Magazin M2 und ganz unten das dritte Magazin M3 angeordnet. Sie sind in nicht dargestellter Weise mechanisch miteinander verbunden. Das zweite Magazin ist also sowohl dem ersten als auch dem dritten benachbart.

Jedes Magazin weist oben und unten je 16 Führungsleisten F auf, in die die Steckbaugruppen geführt werden. Es sind nur die unteren Führungsleisten sichtbar. Von den 48 Steckbaugruppen (16 je Magazin) ist nur die sechzehnte Steckbaugruppe G16 des dritten Magazins M3 dargestellt. Jede Steckbaugruppe trägt als Steckverbinder eine erste und eine zweite Steckerleiste S1 bzw. S2.

Ferner ist eine erste und eine zweite Rückwandleiterplatte L1 bzw. L2 dargestellt. Jede trägt als Gegensteckverbinder zwei Reihen von je 16 Buchsenleisten, wobei die Buchsenleisten B1 bis B16 die obere Reihe und die Buchsenleisten B17 bis B32 die untere Reihe bilden. Die Buchsenleiste B17 und einige weitere, nicht bezeichnete Buchsenleisten sind hier nicht sichtbar. Weiter sind eine dritte und eine vierte Rückwandleiterplatte L3 bzw. L4 vorgesehen. Diese tragen nur eine Reihe von je 16 Buchsenleisten.

Durch gestrichelte Linien ist angedeutet, in welche der Führungsleisten die dargestellte Steckbaugruppe G16 bei ihrem Einstecken geführt wird, welche Lage die Rückwandleiterplatten an der Rückseite der Magazine nach dem Zusammenbau einnehmen sowie daß die Steckerleisten S1 und S2 der dargestellten Steckbaugruppe G16 in die Buchsenleiste B32 der zweiten Rückwandleiterplatte L2 und in eine nicht bezeichnete Buchsenleiste der vierten Rückwandleiterplatte L4 eingreifen. In der gleichen Weise greifen die Steckerleisten der nicht dargestellten Steckbaugruppen in die ihnen zugeordneten Buchsenleisten ein. So ergibt sich eine Zuordnung gemäß der folgenden Tabelle 2 :

(Siehe Tabelle Seite 4 f.)

| Steckbaugruppen G1 bis G16 in Magazin | Stecker-leiste | Rückwand-leiterplatte | Buchsen-leisten |
|---|---|---|---|
| M1 | S1 | L3 | |
| M1 | S2 | L1 | B1 bis B16 |
| M2 | S1 | L1 | B17 bis B32 |
| M2 | S2 | L2 | B1 bis B16 |
| M3 | S1 | L2 | B17 bis B32 |
| M3 | S2 | L4 | |

Die Rückwandleiterplatte L1 umfaßt also den Bereich der Steckerleisten S2 des ersten Magazins M1 und den Bereich der Steckerleisten S1 des zweiten Magazins M2. Der Bereich der Steckerleisten S2 des ersten Magazins M1 ist dem Bereich der Steckerleisten S1 des zweiten Magazins M2 benachbart. Das gleiche gilt sinngemäß für die Rückwandleiterplatte L2.

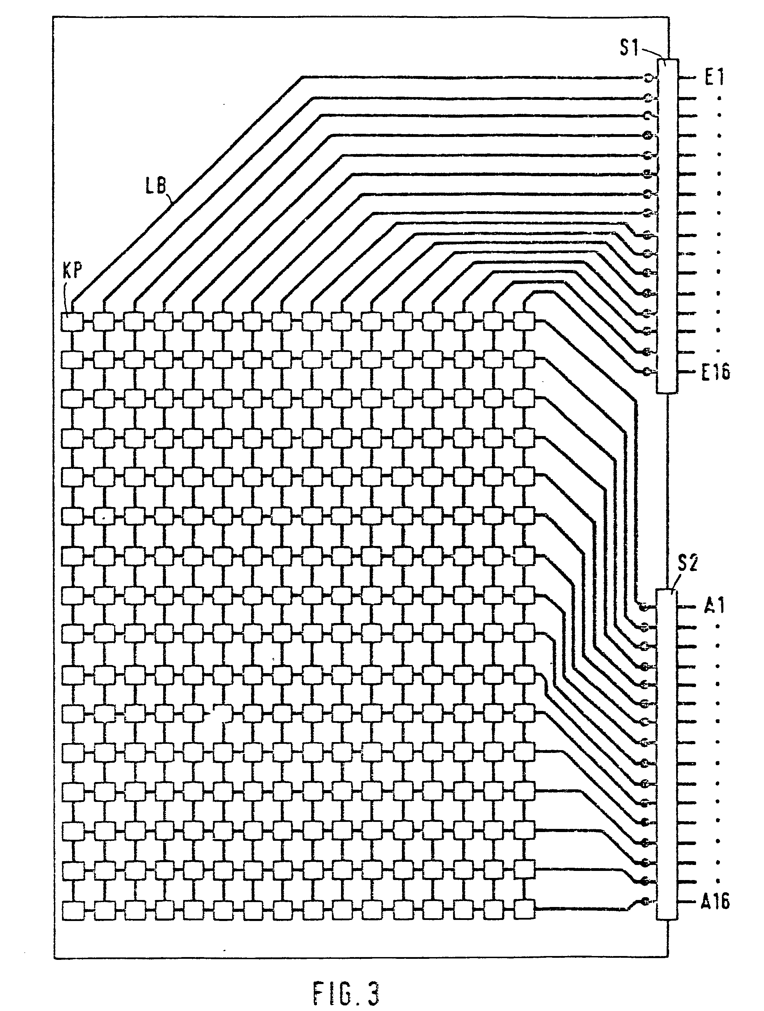

In der Figur 3 ist eine der Steckbaugruppen G1 bis G16 dargestellt. Sie besteht aus einer Leiterplatte LP, welche das aus 256, in einer 16 × 16-Matrix angeordnete Koppelpunkte KP bestehende Teilkoppelfeld, eine erste Steckerleiste S1 und eine zweite Steckerleiste S2 trägt. Die Leiterplatte LP weist Leiterbahnen LB auf, die die Koppelpunkte KP untereinander sowie die 16 Eingänge E1 bis E16 und die 16 Ausgänge A1 bis A16 des Teilkoppelfeldes mit den Steckerleisten S1 bzw. S2 verbinden. Die Eingänge E1 bis E16 sind alle auf der ersten Steckerleiste S1, die Ausgänge A1 bis A16 sind alle auf der zweiten Steckerleiste S2 herausgeführt. Wie aus der Figur 2 hervorgeht, ist bei den Steckbaugruppen des zweiten Magazins M2 die erste Steckerleiste S1 dem ersten Magazin M1 am nächsten gelegen. Deshalb sind auf ihr die Eingänge E1 bis E16 herausgeführt, weil diese gemäß der Figur 1 mit den Ausgängen des ersten Magazins M1 verbunden werden müssen. Das Gleiche gilt sinngemäß für die zweiten Steckerleisten S2 und für die Steckbaugruppen der anderen Magazine.

Die Leiterbahnen LB wurden hier einpolig dargestellt. Da Koppelfelder jedoch üblicherweise zwei- oder gar vieradrig ausgeführt werden, muß man sich anstelle einer Linie zwei bzw. vier Leiterbahnen und auf den Steckerleisten entsprechend viele Steckerstifte vorstellen.

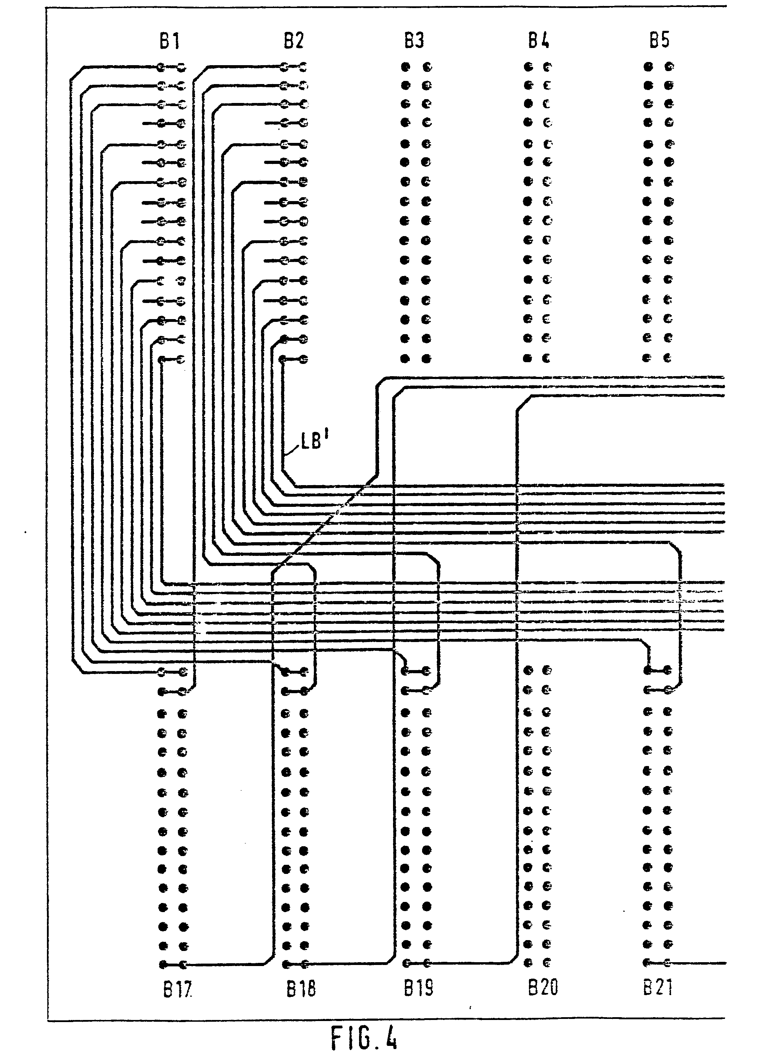

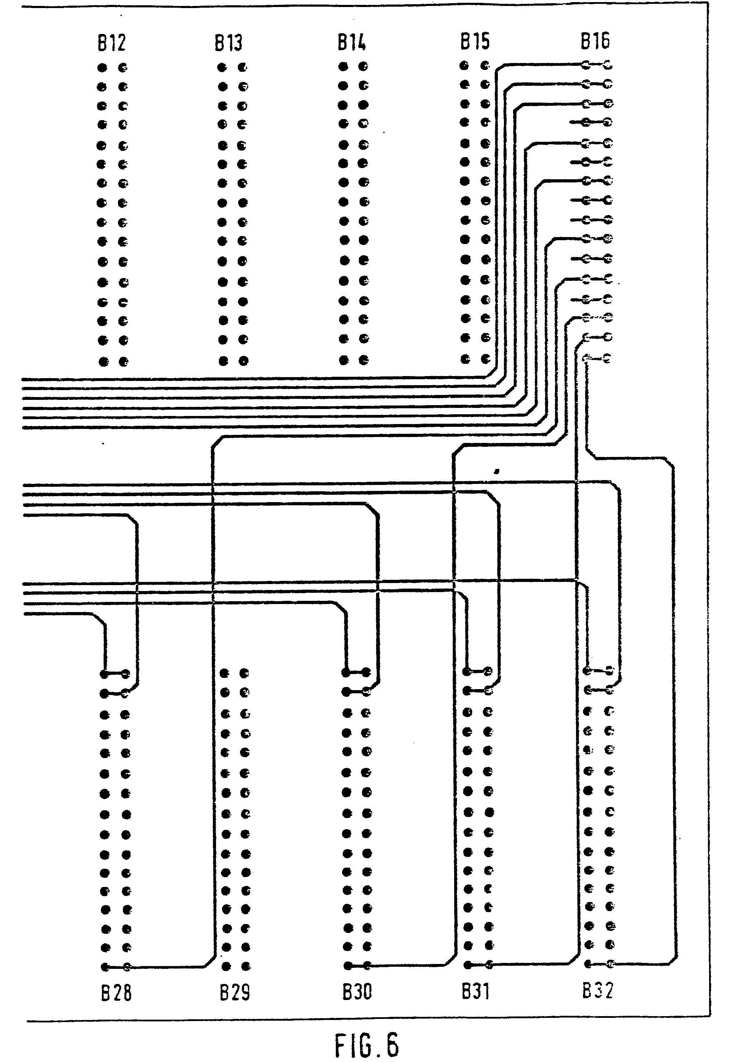

In den Figuren 4, 5 und 6 ist eine der Rückwandleiterplatten L1 bzw. L2 dargestellt. Diese Figuren lege man nebeneinander, die Figur 4 links und die Figur 6 rechts. Die jeweils obere und untere Linie sowie die linke bzw. rechte Linie auf der Figur 4 bzw. 6 geben die Umrisse dieser Rückwandleiterplatte an. Mit B1 bis B16 (obere Reihe) und B17 bis B32 sind die Plätze für die Buchsenleisten B1 bis B32 bezeichnet. Diese Buchsenleisten selbst sind nicht dargestellt, sondern es sind durch Punkte nur die Lötaugen für ihre Lötstifte angedeutet. Betrachtet man die erste Rückwandleiteplatte L1, so liegen, wie aus den Figuren 2 und 3 hervorgeht, auf den Buchsenleisten B1 bis B16 die Ausgänge A1 bis A16 der Steckbaugruppen G1 bis G16 aus dem ersten Magazin M1. Auf den Buchsenleisten B17 bis B32 liegen die Eingänge E1 bis E16 der Steckbaugruppen des zweiten Magazins M2, und zwar jeweils oben mit E1 bzw. A1 beginnend.

Die Verbindungen, die gemäß der Tabelle 1 zu schaffen sind, werden durch Leiterbahnen LB' gebildet. Dabei wurde hier wieder eine einpolige Darstellung gewählt ; und man muß sich anstelle einer Linie zwei Leiterbahnen vorstellen, da, wie an der Darstellung von je zwei Lötaugen für jeden Ein-bzw. Ausgang zu erkennen ist, hier eine Rückwandleiterplatte für ein zweiadriges Koppelfeld gezeichnet ist. Von den vielen, laut Tabelle 1 zu schaffenden Verbindungen sind hier nur einige gezeichnet. Außerdem ist nicht gezeichnet, daß die Leiterbahnen auf verschiedene Ebenen einer Multilayerplatte verteilt sind, um ihre große Zahl unterbringen und ihre Kreuzungen ausführen zu können.

Um Stoßstellen, die gerade bei höherfrequenten Nachrichtensignalen stören, zu vermeiden, sind spitzwinklige Abknickungen der Leiterbahnen ganz vermieden und rechtwinklige in zwei stumpfwinklige aufgelöst. Statt der Auflösung in stumpfwinklige Abknickungen ist eine abgerundete Ausführung möglich. Dies gilt auch für die Leiterbahnen der Steckbaugruppen. Falls sich spitzwinklige Abknickungen nicht vermeiden lassen, werden sie ebenfalls in mehrere stumpfwinklige aufgelöst oder abgerundet ausgeführt.

In diesem Ausführungsbeispiel ist die zweite Rückwandleiterplatte wie die erste ausgeführt, da laut Tabelle 1 das Schema der Verbindungen zwischen der ersten und der zweiten Stufe dem der Verbindungen zwischen der zweiten und dritten Stufe gleicht. Es können aber auch ungleiche Schemen verwirklicht werden, es sind nur verschiedene Rückwandleiterplatten mit entsprechend geführten Leiterbahnen vorzusehen.

4

Es können auch nur durch entsprechende Führung der Leiterbahnen auf den Rückwandleiterplatten von der Tabelle 1 völlig abweichende Schemen verwirklicht werden.

Durch Anwendung der Leiterplattentechnik in Form der erfindungsgemäßen Rückwandleiterplatten weisen die so hergestellten Verbindungen elektrische Eigenschaften (z. B. Nebensprechdämpfung) mit geringen Fertigungsstreuungen auf, und dadurch sind die Verbindungen auch zur Übertragung höherfrequenter Nachrichtensignale geeignet. Durch die möglichen maschinellen Herstellungsverfahren solcher Leiterplatten sind ferner Fehler durch menschliche Irrtümer ausgeschlossen.

Die Darstellung der dritten und vierten Rückwandleiterplatte L3 und L4 in einer eigenen Figur erübrigt sich, da auf ihnen in herkömmlicher Weise die Verbindungen von den Signalquellen zu den Eingängen der ersten Stufe bzw. von den Ausgängen der dritten Stufe zu den Nachrichtensenken hergestellt werden. Nicht dargestellt sind ferner Schaltmittel und Steuerleitungen zum Durchschalten und Ausschalten der Koppelpunkte. Dies gilt auch für die Steckbaugruppen.

Die Figur 7 zeigt einen Schnitt durch eine Multilayerplatte, um die Lage der Leiterbahnen in ihr darzustellen. Sie weist neun Schichten auf, zwischen denen die schraffiert gezeichneten Leiterbahnen liegen. Es wird ein zweiadrig aufgebautes Koppelfeld angenommen, d. h., jede Verbindung ist als ein Paar von Leiterbahnen ausgeführt. Das erste Paar ist mit LB1 bezeichnet und liegt in der ersten Ebene zwischen der ersten und zweiten Schicht. Um auch bei höherfrequenten Nachrichtensignalen eine ausreichend hohe Nebensprechdämpfung zu erreichen, ist das zweite Paar LB2 in der nächsten Ebene nicht unmittelbar neben dem ersten Paar LB1 angeordnet, sondern entsprechend der Nebensprechdämpfungsforderung seitlich versetzt. Diese Versetzung erstreckt sich über vier Ebenen. Die gegebenen Nebensprechdämpfungsforderungen erlauben es erst, in der fünften Ebene wieder ein Paar LB3 ohne Versetzung gegenüber dem ersten Paar LB1 anzuordnen.

Das erfindungsgemäße Aufbausystem ist besonders gut geeignet zum Aufbau von Breitband-Koppelfelder in Breitband-Kommunikationssystemen, in denen u. a. digitalisierte Fernsehsignale mit hohen Bitraten übertragen werden. Durch die Weiterbildung nach dem Anspruch 2 ist es auch für Kommunikations-systeme mit Bitraten von 140 MBit/s geeignet.

Mit dem erfindungsgemäßen Aufbausystem können jedoch nicht nur mehrstufige Koppelfelder sondern auch andere, aus mehreren Stufen bestehende elektrische Geräte aufgebaut werden, bei denen Steckbaugruppen stufenweise geordnet in Magazinen untergebracht werden und wo zwischen den benachbarten Magazinen viele elektrische Verbindungen notwendig sind.

Die Steckbaugruppen und Magazine des erfindungsgemäßen Aufbausystems können aus den genormten und handelsüblichen Teilen des Intermas-Aufbausystems hergestellt werden, so daß keine Sonderkonstruktionen erforderlich sind. Auch die Herstellung der Rückwandleiterplatten wirft keine neuen Probleme auf, da sie nicht größer sind als die im Intermas-Aufbausystem üblichen.

**Patentansprüche**

1. Aufbausystem für Geräte der elektrischen Nachrichtentechnik, wobei Steckbaugruppen in Magazine (M1 bis M3) untergebracht sind, die Steckbaugruppen an einer Kante mehrere Steckverbinder (S1, S2) zum Herausführen von Eingängen (E1 bis E16) und Ausgängen (A1 bis A16) tragen, welche in an Rückwandleiterplatten angebrachten Gegensteckverbindern (B1 bis B32) eingreifen, die Rückwandleiterplatten an den Magazinen befestigt sind und wobei elektrische Verbindungen zwischen den Eingängen (E1 bis E16) und Ausgängen (A1 bis A16) der Steckbaugruppen (G1 bis G16) benachbarter Magazine bestehen, gekennzeichnet durch folgende Merkmale :

a) eine dieser Rückwandleiterplatten (L1 bzw. L2) umfaßt die zwei benachbarten Bereiche zweier benachbarter Magazine und trägt als Leiterbahnen die elektrischen Verbindungen (Fig. 2, 4, 5, 6) ;

b) die Eingänge (E1 bis E16) und die Ausgänge (A1 bis A16) sind auf demjenigen von den mehreren Steckverbindern (S1 bzw. S2) herausgeführt, welcher demjenigen Magazin (M1, M2 bzw. M3) am nächsten liegt, mit dem diese Eingänge (E1 bis E16) bzw. Ausgänge (A1 bis A16) verbunden werden müssen (Fig. 3).

2. Aufbausystem für Geräte der elektrischen Nachrichtentechnik nach Anspruch 1, gekennzeichnet durch folgende Merkmale :

c) die Rückwandleiterplatten (L1, L2) sind in Multilayer-Technik ausgeführt ;

d) in verschiedenen Ebenen der Rückwandleiterplatte parallel laufende Leiter oder Leiterpaare (LB1, LB2, LB3) sind gegenseitig versetzt ;

e) die Weite der Versetzung und die Zahl der Ebenen, über die sie sich erstreckt sind so bemessen, daß die geforderte Nebensprechdämpfungswerte zwischen den Leitern bzw. Leiterbahnen eingehalten werden (Fig. 7) ;

f) spitzwinklige und rechtwinklige Leiterbahnabknickungen sind entweder abgerundet ausgeführt oder in mehrere stumpfwinklige Abknickungen aufgelöst (Fig. 4, 5, 6).

**Claims**

1. Assembly system for electrical communications devices wherein plug-in modules are accommodated in magazines (M1 to M3), said plug-in modules are provided, at one of their edges, with a plurality of plug-in connectors (S1, S2) for bringing out inputs (E1 to E16) and outputs (A1 to A16), said plug-in connectors engaging in female connectors (B1 to B32) attached to rear wall circuit boards, said rear wall circuit boards being fastened to the magazines and electrical connections are established between the inputs (E1 to E16) and outputs (A1 to A16) of the plug-in modules (G1 to G16) of adjacent magazines, characterised by the following features :

a) one of said rear wall conductor plates (L1, L2) covers the two adjacent regions of two adjacent magazines and carries conductor paths which establish the electrical connections (Figures 2, 4, 5, 6) ;

b) the inputs (E1 to E16) and the outputs (A1 to A16) are brought out of that one of the plurality of plug-in connectors (S1, S2) which lies closest to that magazine (M1, M2, M3) with which these inputs (E1 to E16) and outputs (A1 to A16), respectively, must be connected (Figure 3).

2. Assembly system for electrical communications devices according to claim 1, characterised by the following features :

c) the rear wall circuit boards (L1, L2) are configured in multilayer technology ;

d) conductors or pairs of conductors (LB1, LB2, LB3) extending parallel to one another in different planes of the rear wall circuit board are offset with respect to one another ;

e) the width of the offset and the number of planes over which said offset extends are dimensioned in such a manner that required crosstalk attenuation values are maintained between the conductors and conductor paths (Figure 7) ;

f) acute angle and rectangular bends in the conductor paths are either rounded off or are opened up into a plurality of obtuse angle bends (Figures 4, 5, 6).

**Revendications**

1. Système de montage pour appareils de la technique des communications électriques, comprenant des unités enfichables logées dans des magasins (M1 à M3), les unités enfichables portant sur un bord plusieurs connecteurs à enfichage (S1, S2) pour sortir des entrées (E1 à E16) et des sorties (A1 à A16), connecteurs qui coopèrent avec des connecteurs (B1 à B32) disposés sur des plaques à circuits imprimés formant paroi arrière, lesquelles sont fixées aux magasins, et dans lequel des liaisons électriques existent entre les entrées (E1 à E16) et les sorties (A1 à A16) des unités enfichables (G1 à G16) de magasins voisins, caractérisé en ce que :

a) l'une des plaques à circuits imprimés formant paroi arrière (L1 ou L2) couvre les deux zones voisines de deux magasins voisins et porte les liaisons électriques, constituées par des pistes conductives (figures 2, 4, 5, 6) ;

b) les entrées (E1 à E16) et les sorties (A1 à A16) sont sorties sur le connecteur à enfichage (S1 ou S2) qui, parmi les différents connecteurs à enfichage prévus, est situé le plus près des magasins (M1, M2 ou M3) auquel ces entrées (E1 à E16) ou ces sorties (A1 à A16) doivent être reliées (figure 3).

2. Système selon la revendication 1, caractérisé en ce que :

c) les plaques à circuits imprimés formant paroi arrière (L1, L2) sont réalisées en technique multicouche ;

d) un décalage est prévu entre des conducteurs ou des paires de conducteurs (LB1, LB2, LB3) s'étendant parallèlement en différents plans d'une plaque à circuits imprimés formant paroi arrière ;

e) l'étendue en largeur du décalage et le nombre des plans sur lequel il s'étend sont choisis de manière que les valeurs requises d'affaiblissement diaphonique entre les conducteurs ou les paires de conducteurs soient respectées (figure 7) ;

f) les changements de direction à angle aigu ou à angle droit des pistes conductives sont exécutés avec des arrondis ou sont décomposés en plusieurs changements de direction à angle obtus (figures 4, 5, 6).

FIG.1

0 191 902

FIG. 2

FIG. 3

B1  B2  B3  B4  B5

LB'

B17  B18  B19  B20  B21

FIG. 4

FIG. 5

FIG.6

FIG. 7

0 191 902